# EUROPEAN PATENT SPECIFICATION

(11) **EP 3 211 679 B1**
(45) Date of publication and mention of the grant of the patent: **04.11.2020**
(21) Application number: 17165008.8
(22) Date of filing: 14.05.2013
(51) Int. Cl.: H01L 33/62, H01L 33/64, H01R 33/06, F21V 19/00

(54) **HOUSING FOR ELECTRIC PARTS**
GEHÄUSE FÜR ELEKTRISCHE KOMPONENTEN
BOÎTIER POUR DES COMPOSANTS ÉLECTRIQUES

(30) Priority: 06.06.2012 JP 2012129049
(43) Date of publication of application: 30.08.2017
(62) Divisional of application: 13167653.8
(73) Proprietor: Dai-Ichi Seiko Co., Ltd., Kyoto-shi, Kyoto 612-8024 (JP)
(72) Inventor: ENDO, Takayoshi, Shizuoka-shi, Shizuoka 4200857 (JP); YAGI, Sakai, Shizuoka-shi, Shizuoka 4200857 (JP); SENMYOU, Masaru, Shizuoka-shi, Shizuoka 4200857 (JP)
(74) Representative: Winter, Brandl, Fürniss, Hübner, Röss, Kaiser, Polte - Partnerschaft mbB

(56) References cited:
- EP-A1- 2 327 285
- JP-A- 2005 302 614
- US-A1- 2011 103 076

## Description

### BACKGROUND OF THE INVENTION

### FIELD OF THE INVENTION

The invention relates to a housing used for electric parts, capable of effectively radiating heat generated in an electric component which generates heat when a current runs therethrough.

### DESCRIPTION OF THE RELATED ART

An electric component such as a transistor, a diode, a resistor or a capacitor generates heat when a current runs therethrough. In particular, a light-emitting diode (LED) generates much heat, because a much current runs therethrough for accomplishing high luminance. If LED were kept at a high temperature, a lifetime thereof would be shortened. Accordingly, it is necessary to avoid a temperature of LED from rising, for instance, by radiating heat generated in electric components into ambient atmosphere, or transferring heat to other components.

For instance, JP 2008-288487 A has suggested a light-emitting diode including a circuit board having a multi-layered structure. Intermediate layers are comprised of a copper foil pattern having a function of heat radiation. An upper surface electrode on which a LED chip is mounted is electrically connected to the intermediate layers through filled via-holes to thereby radiate heat generated in the LED chip into the intermediate layers. JP 2005 302 614 A discloses a housing according to the preamble of claim 1.

### SUMMARY OF THE INVENTION

However, since heat is radiated to the intermediate layers comprised of a copper foil pattern in the above-mentioned conventional light-emitting diode, the circuit board has to be designed to have a multi-layered structure, resulting in the complexity in a structure thereof. Furthermore, a circuit board can be employed if an electric part is in the form of a thin plate, but it is not possible to apply the technique for manufacturing the circuit including intermediate layers to a housing used for an electric part and formed by resin molding in a three-dimensional shape.

In view of the above-mentioned problem in the prior art, it is an object of the present invention to provide a housing capable of preventing an electric part from rising in temperature, being formed in a simple structure, and further, being readily formed in a desired shape.

One of the aspect of the present invention is that it provides a housing used for an electric part, including a wire section electrically connected to an electric circuit including an electric component, and a housing body composed of resin, the wire section includes a first terminal part exposed at a surface of the housing body, a second terminal part exposed at a surface of the housing body, and a thermally conductive part formed between the first terminal part and the second terminal part, and embedded in the housing body, the thermally conductive part has a width greater than the same of the first and second terminal parts.

In the housing in accordance with the present invention, heat generated in an electric part is radiated to the wire section. Since the wire section is designed to include the thermally conductive part embedded in the housing body, it is possible to radiate the heat into the housing body from the thermally conductive part. Since the heat is radiated into ambient atmosphere from the housing body, it is possible to prevent the temperature of the electric part from rising. Since the housing body can be formed by resin molding, the housing body can be formed in a desired two-dimensional or three-dimensional shape. Furthermore, since the housing can be manufactured only by embedding the thermally conductive part in resin, the housing is simple in structure.

It is preferable that the thermally conductive part has an area extensive almost over the housing body. For instance, the thermally conductive part may be designed to have an area almost equal to an area of the housing body. By designing the thermally conductive part to have an area as much as possible, an efficiency of heat radiation can be enhanced.

It is preferable that the wire section is bent at least once. By bending the wire section at least once, the wire section can be longer than a wire section designed to be straight, ensuring a larger area of the thermally conductive part.

It is preferable that the thermally conductive part comprises a plurality of vertically or horizontally arranged layers. By designing the thermally conductive part to have a plurality of layers, the thermally conductive part can have a greater area than an area of a thermally conductive part comprised of a single layer, ensuring a higher efficiency of heat radiation.

For instance, the adjacent layers may be designed to connect to each other through a bending part formed at peripheries of the adjacent layers.

It is preferable that the number of the layers is an odd number which equal to or greater than 3.

It is preferable that at least a part of the thermally conductive part is exposed externally of the housing body. By designing at least a part of the thermally conductive part to be exposed externally of the housing body, an efficiency of heat radiation can be enhanced.

For instance, at least a part of the thermally conductive part horizontally and/or vertically may be designed to project externally of the housing body. For another instance, the housing body may be formed with at least one hole leading to the thermally conductive part.

It is preferable that the housing body is formed by insert molding with the wire section being embedded therein. By carrying out insert molding, it is possible to readily embed the thermally conductive part in the housing body at a desired location, when the housing body is formed.

It is preferable that the electric circuit comprises a pattern comprising a thin metal film electrically connected to the electric component, the pattern being formed by a wiring pattern transfer process in which a thin metal film sheet is dice-cut, and the dice-cut sheet is tranferred to the housing body.

The wiring pattern transfer process makes it possible to directly form a thin metal film pattern in the housing body formed by resin molding, and hence, it is possible to radiate heat generated in an electric component directly to ambient atmosphere or through the pattern comprised of a thin metal film, or to the housing body, preventing a temperature of the electric component from rising.

### ADVANTAGES OBTAINED BY THE INVENTION

In accordance with the present invention, the heat generated in the electric circuit is radiated into the housing body through the thermally conductive part. Since the housing body in which the thermally conductive part is embedded is formed by resin molding, the housing can be readily formed in a desired shape in a simple structure with a temperature at the electric component being prevented from rising.

### BRIEF DESCRIPTION OF THE DRAWINGS

Figure 1 is a perspective view of the LED lamp in accordance with the first embodiment of the present invention.
Figure 2 is a plan view of the LED lamp illustrated in Figure 1.
Figure 3 is a circuit diagram of the electric circuit included in the LED lamp illustrated in Figure 1.
Figure 4 is a cross-sectional view taken along the line A-A in Figure 2.
Figure 5 is a perspective view of the wire section included in the LED lamp illustrated in Figure 2.
Figure 6 is a perspective view of the LED lamp including the first terminal part as a variant.
Figure 7 is a cross-sectional view of the LED lamp illustrated in Figure 6.
Figure 8 is a cross-sectional view of the LED lamp in accordance with the second embodiment of the present invention.
Figure 9 is a perspective view of the wire section included in the LED lamp illustrated in Figure 8.
Figure 10 is a perspective view showing a process of embedding the wire section illustrated in Figure 8 into the housing main body by insert molding.
Figure 11(A) is a front view of the wire section illustrated in Figure 10.
Figure 11(B) is a cross-sectional view taken along the line B-B in Figure 11(A).
Figure 12 is a perspective view of the housing formed by insert molding.
Figure 13 is a perspective view of the housing illustrated in Figure 12 on which the circuit patterns are formed.
Figure 14 is a perspective view of the wire section included in the LED lamp in accordance with the third embodiment.
Figure 15 is a cross-sectional view of the LED lamp in accordance with the third embodiment.
Figure 16 is a cross-sectional view of the LED lamp in accordance with the fourth embodiment.
Figure 17 is a cross-sectional view of the LED lamp in accordance with a variant of the fourth embodiment.
Figure 18 is a cross-sectional view of the LED lamp in accordance with the fifth embodiment.
Figure 19 is a perspective view of the LED lamp in accordance with the sixth embodiment of the present invention.
Figure 20 is a perspective view of the wire section included in the LED lamp illustrated in Figure 19.
Figure 21 is a perspective view of the LED lamp in accordance with the seventh embodiment of the present invention.
Figure 22 is a perspective view of the wire section included in the LED lamp illustrated in Figure 20.

### DESCRIPTION OF THE PREFERRED EMBODIMENTS

### (First Embodiment)

The housing in accordance with the first embodiment of the present invention is applied to a LED lamp.

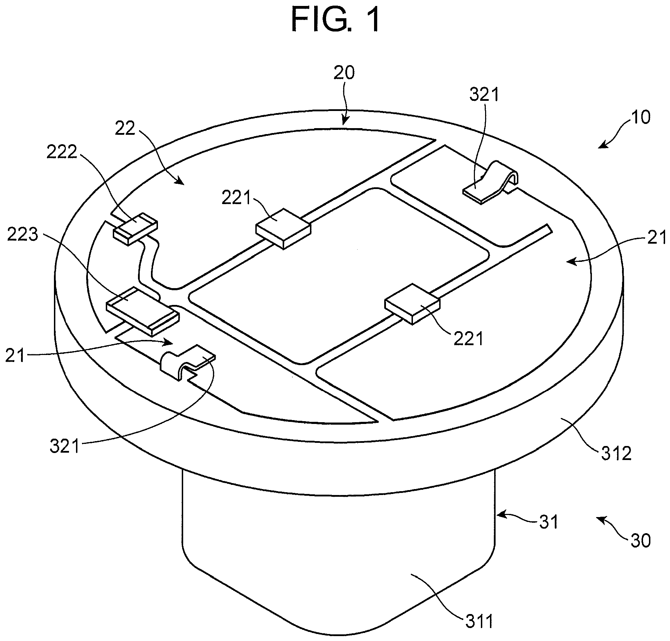

A LED lamp 10 can be used as a head light, a position light, a winker, a brake light and so on in an automobile. As illustrated in Figure 1, the LED lamp 10 includes an electric circuit 20 and a housing 30.

The electric circuit 20 includes circuit patterns 21 each comprised of a thin metal film, and electric components 22 electrically connected to the circuit patterns 22.

Each of the circuit patterns 21 is comprised of a patterned thin metal film, and can be formed by a wiring pattern transfer process in which a thin metal film sheet is dice-cut, and the dice-cut sheet is tranferred onto a surface of the housing 30 (a surface on which the electric circuit 20 is formed).

The electric components 22 in the first embodiment includes, as an example for defining a LED lamp, two LEDs 221, a chip resistor 222, and a diode 223, all mounted on the circuit patterns 21.

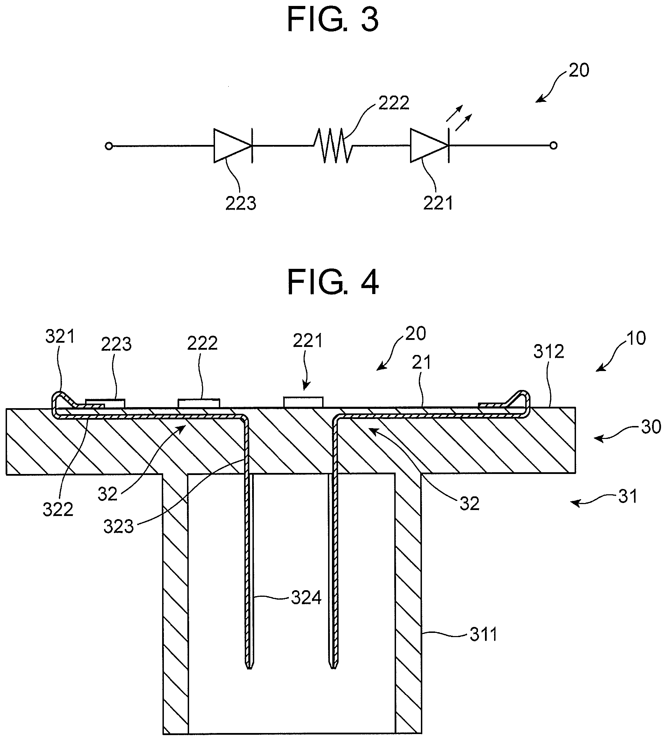

The circuit patterns 21 and the electric components 22 define the electric circuit 20 having a structure as illustrated in Figure 3. In the circuit illustrated in Figure 3, a LED 221, a chip resistor 222 and a diode 223 are electrically connected in series to one another.

As illustrated in Figure 4, the housing 30 is comprised of molded resin formed by inserting molding. The housing 30 includes a housing main body 31, and a wire section 32 which provides electric power to the electric circuit 20. The housing main body 31 includes a base 311 to be fit into an electric power source (not illustrated), and a flange 312 which is formed at a top of the base 311 and on which the electric circuit 20 is formed.

The base 311 is substantially cylindrical. The flange 312 is in the form of a disc having a diameter greater than the same of the base 311.

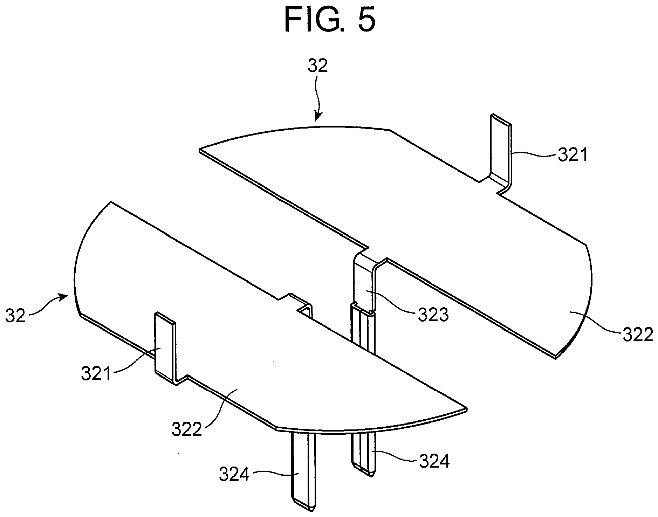

As illustrated in Figures. 4 and 5, the wire section 32 includes a first terminal part 321 electrically connected to the circuit patterns 21 of the electric circuit 20, a thermally conductive part 322 embedded in the housing main body 31, a downwardly extending junction part 323, and a second terminal part 324 projecting externally of the flange 312 into a space formed in the base 311. The wire section 32 can be formed by pressing a metal plate.

The first terminal part 321 is formed by bending a distal end of the wire section 32 externally projecting through a surface of the flange 312 to thereby make surface contact with the circuit patterns 21 (see Figure 1). The first terminal part 321 is soldered to the circuit patterns 21. Figure 5 illustrates the first terminal part 321 at such a shape as before it is bent.

The thermally conductive part 322 is formed between a bent portion of the first terminal part 321 and a bent portion of the junction part 323. As illustrated in Figure 5, the thermally conductive part 322 is designed to have a width greater than widths of the first terminal part 321 and the junction part 323 between which the thermally conductive part 322 is formed. In the first embodiment, the thermally conductive part 322 is designed to be almost trapezoidal, having an oblique line which is arcuate along a circular periphery of the flange 312.

The second terminal part 324 exposed externally of the flange 312, and is designed to be thick by folding a portion having a width greater than the same of the junction part 323 in order to enhance a strength of the second terminal part 324.

The LED lamp 10 having the above-mentioned structure, in accordance with the first embodiment, is used as follows.

By fitting the LED lamp 10 into a power supply, electric power is supplied to the electric circuit 20 through the second terminal part 324 and then the first terminal part 321.

In the electric circuit 20, electric power is supplied to LED 221 through both the chip resistor 222 and the diode 223 from the circuit patterns 21 to which the first terminal part 321 is electrically connected. Thus, LED 221 emits light.

When LED 221 emits light, it generates heat. The thus generated heat partially radiates through the circuit patterns 21 formed by the wire pattern transfer process to have an increased width generate heat, and partially transfers into the housing 30 from the circuit patterns 21. The heat having transferred into the housing 30 is radiated externally of the LED lamp 10. The heat having transferred to the circuit patterns 21 further transfers to the thermally conductive part 322 through the first terminal part 321.

Since the thermally conductive part 322 is designed to have an area larger than the first and second terminal parts 321 and 324, the thermally conductive part 322 can have a large area at which the thermally conductive part 322 makes contact with the housing main body 31. Accordingly, the heat having transferred to the thermally conductive part 322 can be effectively transferred to the housing main body 31, and further, the heat having transferred to the housing main body 31 can be radiated to ambient atmosphere therearound. Furthermore, the heat having transferred to the thermally conductive part 322 can be partially transferred to an electric power source through the junction part 323 and the second terminal part 324.

Furthermore, since the thermally conductive part 322 is located in parallel with and in the vicinity of a surface of the flange 312 on which the circuit patterns 21 are formed, the heat having transferred to the thermally conductive part 322 through the housing main body 31 from the circuit patterns 21 can be spread to entire housing main body 31, and then, radiated out of the housing main body 31.

As mentioned above, since the heat having transferred to the thermally conductive part 322 is radiated to ambient atmosphere through the housing 30, it is possible to avoid a temperature of LED 221, an electric component, from rising. Since the housing 30 is formed by resin molding, the housing 30 can be readily formed to a desired shape, even if it is two-dimensional or three-dimensional. Furthermore, since the housing 30 in which the wire section 32 is embedded and which is composed of resin is formed by insert molding, the housing 30 can be formed in a simple structure, and the wire section 32 can be embedded in the housing 30 at a desired location.

In the first embodiment, the wire section 32 is perpendicularly bent between the first terminal part 321 and the thermally conductive part 322, the thermally conductive part 322 is located in parallel with a surface of the flange 312, and the wire section 32 is further bent between the thermally conductive part 322 and the junction part 323, and accordingly, the wire section 32 can have a path longer than a path of a wire section straightly formed from a bottom of the flange 312 to the first terminal part 312. Thus, since it is possible to design the thermally conductive part 322 to have a large area, heat can be effectively transferred to the housing main body 31 from the thermally conductive part 32.

By forming the circuit patterns 21 by means of the wire pattern transfer process, the circuit patterns 21 can be formed as a widespread plain pattern, heat having transferred from LED 221 can be radiated out of the circuit patterns 21.

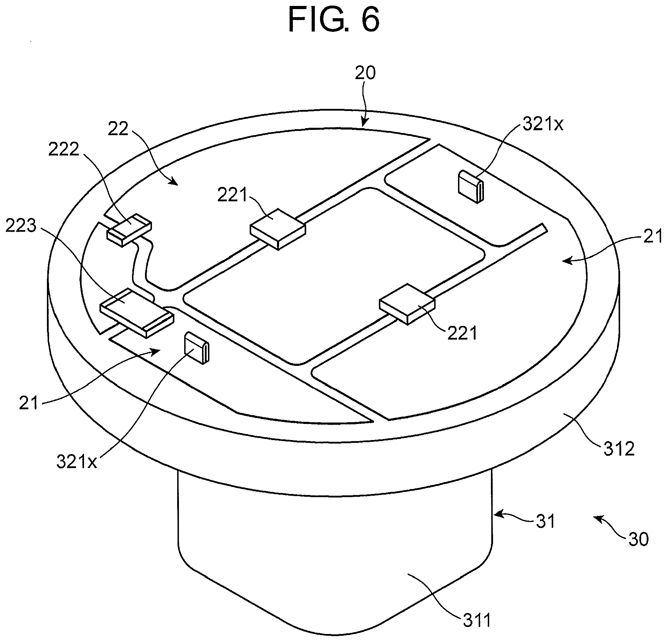

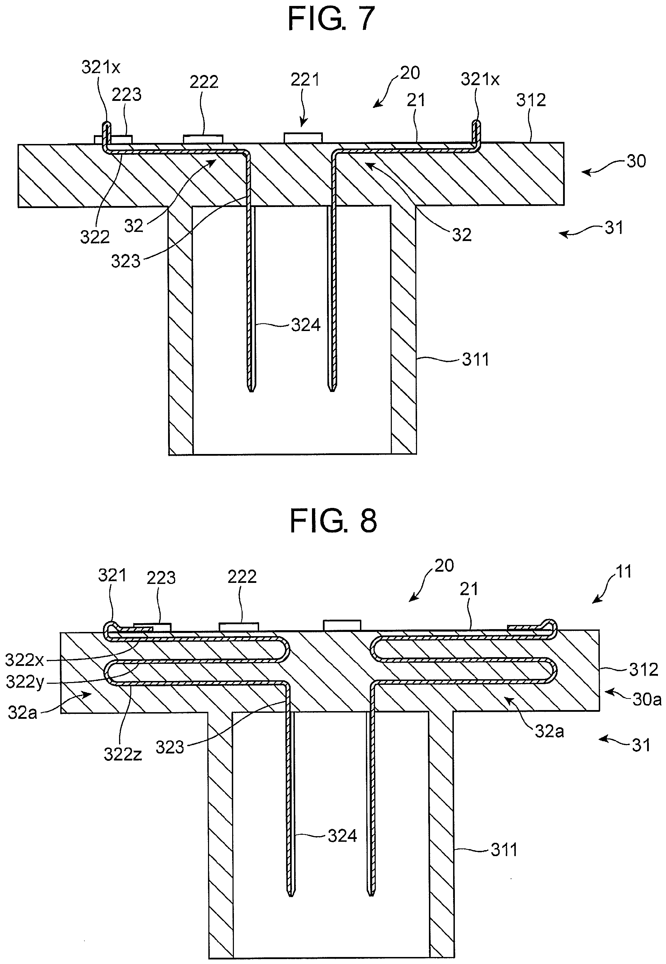

In the LED lamp 10 in accordance with first embodiment, the first terminal part 321 is bent at a distal end thereof to thereby make surface contact with the circuit patterns 21. Instead, as illustrated in Figures 6 and 7, the first terminal part 321x may be formed by folding a distal end of the wire section 32, and a portion of the wire section 32, exposed out of the housing main body 31, may be soldered to the housing 30.

### (Second Embodiment)

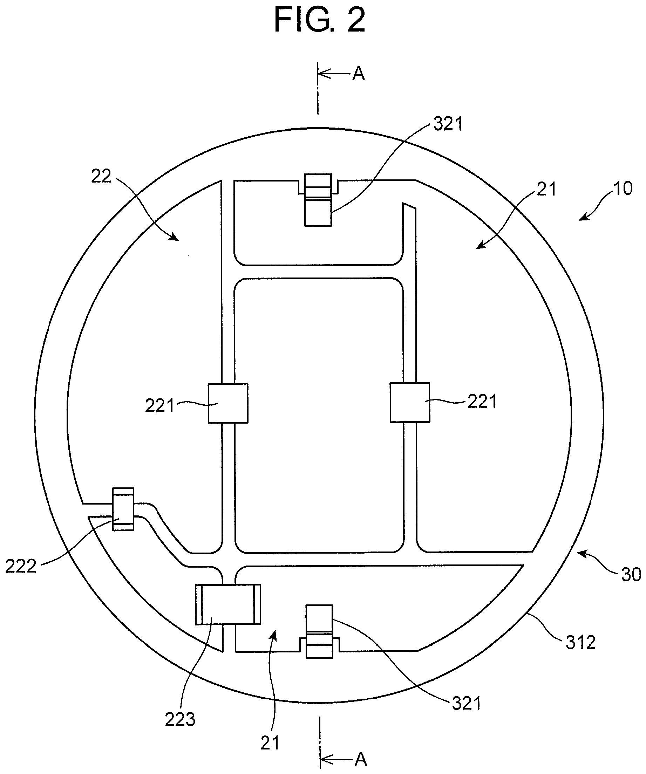

A housing to be used for an LED lamp, in accordance with the second embodiment of the present invention is explained hereinbelow with reference to drawings. The LED lamp in accordance with the second embodiment is characterized in including a thermally conductive part comprising a plurality of layers. In Figures 8 to 13, parts or elements that correspond to those of the first embodiment illustrated in Figures 1 to 7 have been provided with the same reference numerals, and operate in the same manner as corresponding parts or elements in the first embodiment, unless explicitly explained hereinbelow.

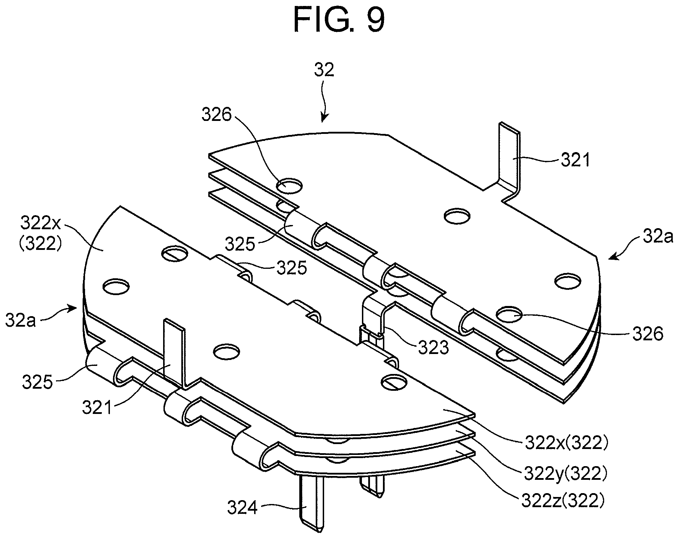

As illustrated in Figures 8 and 9, LED lamp 11 in accordance with the second embodiment includes a wire section 32a having a thermally conductive part 322 between the first terminal part 321 and the junction part 323. The thermally conductive part 322 comprises vertically arranged three layers, that is, first to third thermally conductive parts 322x, 322y and 322z.

As illustrated in Figure 9, the first to third thermally conductive parts 322x, 322y and 322z are connected to one another through a bending part 325, and thus, the first to third thermally conductive parts 322x, 322y and 322z can be formed of a single plate. Specifically, the first thermally conductive part 322x starts at a bending portion of the first terminal part 321, and is connected to the second thermally conductive part 322y through the bending part 325. Then, the second thermally conductive part 322y is connected to the third thermally conductive part 322z through the bending part 325. Thus, the first and second thermally conductive parts 322x and 322y define a reciprocated route via the bending part 325 in the wire section 32a. Furthermore, since the third thermally conductive part 322z is connected to the second thermally conductive part 322y via the bending part 325, the second terminal part 324 can be designed to project out of a lower surface of the flange 312 at a center of the flange 312, similarly to the LED lamp 10 in accordance with the first embodiment. The bending part 325 comprises three parts for connecting the first to third thermally conductive parts 322x to 322z to one another.

As illustrated in Figure. 9, each of the first to third thermally conductive parts 322x to 322z arranged in parallel with one another is formed with through-holes 326 into which a pole can be perpendicularly inserted.

Herein, a process for forming the housing main body 31 by insert molding with the wire section 32a being embedded therein is explained with reference to drawings.

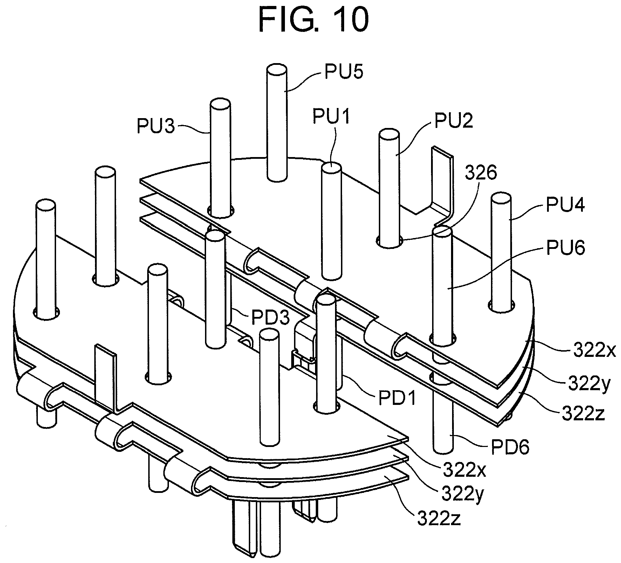

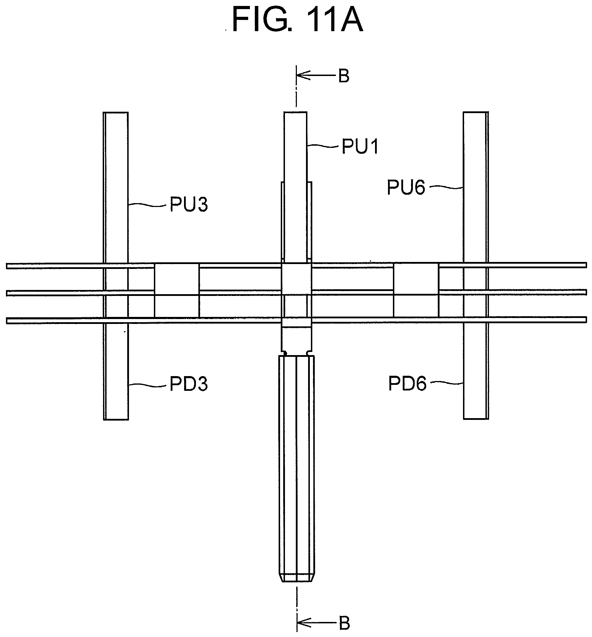

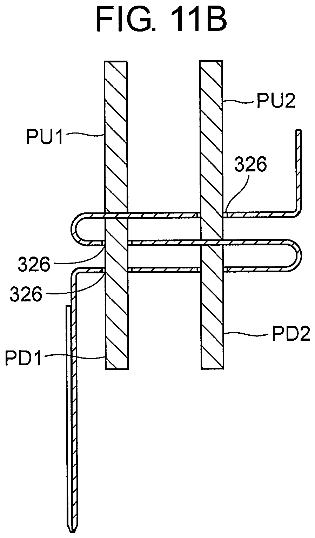

As illustrated in Figures 10 and 11, in the insert molding, poles for fixation PU1 to PU6 compress one of upper and lower surfaces (upper surfaces in Figure 10) of the first to third thermally conductive parts 322x to 322z, and poles for fixation PD1 to PD6 compress the other surfaces (lower surfaces in Figure 10) of the first to third thermally conductive parts 322x to 322z to thereby sandwich the first to third thermally conductive parts 322x to 322z between the poles PU1 to PU6 and the poles PD1 to PD6.

For instance, as illustrated in Figure 11(B), the pole PU1 compresses an upper surface of the first thermally conductive part 322x, and the pole PD1 facing the pole PU1, which passes through the through-hole 326 of the third thermally conductive part 322z and the through-hole of the second thermally conductive part 322y, compresses a lower surface of the first thermally conductive part 322x. Thus, the first thermally conductive part 322x is sandwiched by the poles PU1 and PD1.

Similarly to the poles PU1 and PD1, as illustrated in Figure 11(B), the pole PU2 passes through the through-hole 326 of the first thermally conductive part 322x and compresses an upper surface of the second thermally conductive part 322y, and the pole PD2 facing the pole PU2 passes through the through-hole 326 of the third thermally conductive part 322z and compresses a lower surface of the second thermally conductive part 322y. Thus, the second thermally conductive part 322y is sandwiched by the poles PU2 and PD2.

Similarly, the poles PU3 and PD3 sandwiches the third thermally conductive part 322z therebetween, the poles PU4 and PD4 sandwiches the third thermally conductive part 322z therebetween, the poles PU5 and PD5 sandwiches the first thermally conductive part 322x therebetween, and the poles PU6 and PD6 sandwiches the second thermally conductive part 322y therebetween.

By sandwiching the first to third thermally conductive parts 322x to 322z between the poles PU1 to PU6 and the poles PD1 to PD6, the first to third thermally conductive parts 322x to 322z can be spaced away from one another by a certain distance, even if molten resin flowed into a metal mold.

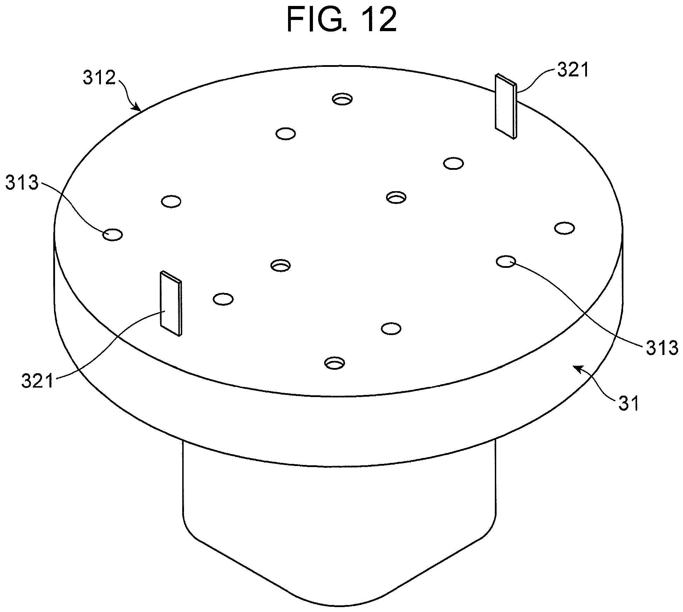

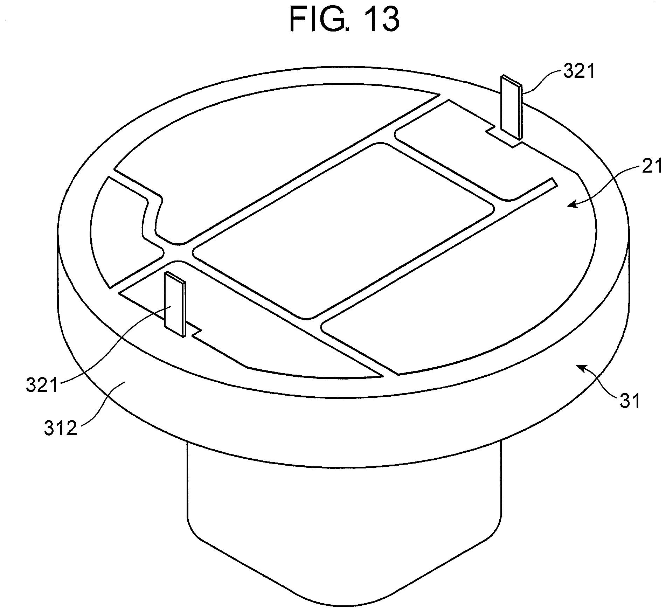

As illustrated in Figure 12, the housing main body 31 in which the thermally conductive part 322 is embedded and which is formed by insert molding is formed holes 313 due to the poles PU1 to PU6 and PD1 to PD6. However, as illustrated in Figure 13, since the circuit patterns 21 are formed by the wire pattern transfer process on an upper surface of the flange 312 of the housing main body 31, the holes 313 (see Figure 12) are closed, resulting in that the holes 313 cannot be seen in appearance of the housing 30.

As mentioned above, since the LED lamp 11 in accordance with the second embodiment includes the housing 30a having the multi-layered thermally conductive part 322, the thermally conductive part 322 can have a large area, ensuring heat radiation at a high efficiency. Furthermore, since the first to third thermally conductive parts 322x to 322z are arranged in parallel to one another by a certain distance, the thermally conductive part 322 can be designed to have a multi-layered structure, ensuring that the thermally conductive part 322 can have a larger area in a small volume of the housing main body 31.

In the LED lamp 11 in accordance with the second embodiment, the first to third thermally conductive parts 322x to 322z are designed to be identical in shape with one another. Instead, the first to third thermally conductive parts 322x to 322z may be designed to be different in shape from one another in dependence on a shape of the housing 30.

### (Third Embodiment)

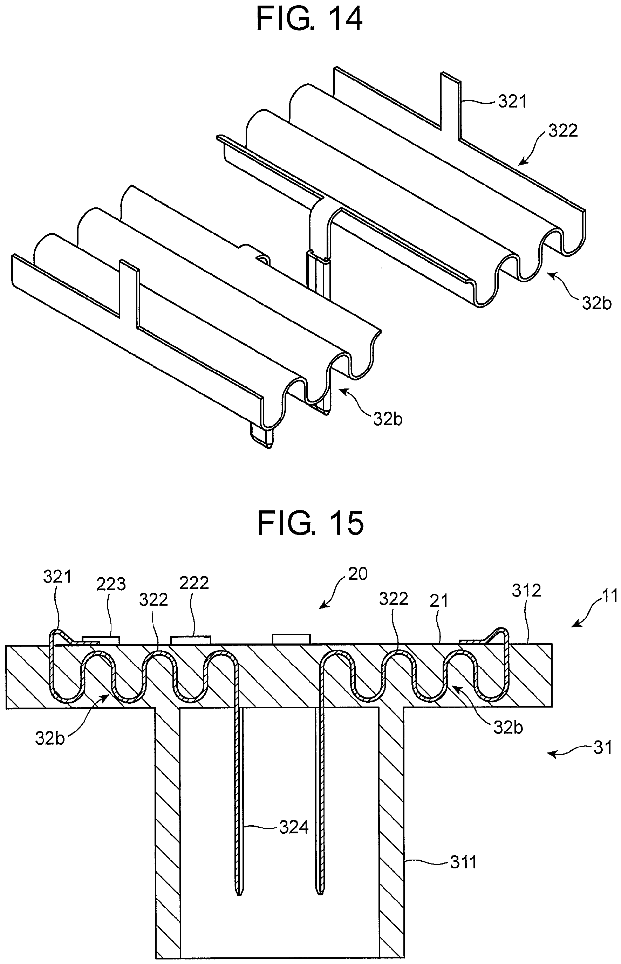

Figure 14 is a perspective view of the wire section 32b to be employed in the housing in accordance with the third embodiment, and Figure 15 is cross-sectional view of the housing in accordance with the third embodiment.

In the second embodiment, as illustrated in Figure 8, the thermally conductive part 322 is designed to have a multi-layered structure including the first to third thermally conductive parts 322x , 322y and 322z vertically arranged. In the third embodiment, the thermally conductive part 322 is designed to have a multi-layered structure including a plurality of layers horizontally arranged. The thermally conductive part 322 may be designed to have a multi-layered structure including any number of layers.

The third embodiment provides the same advantages as those provided by the second embodiment.

### (Fourth Embodiment)

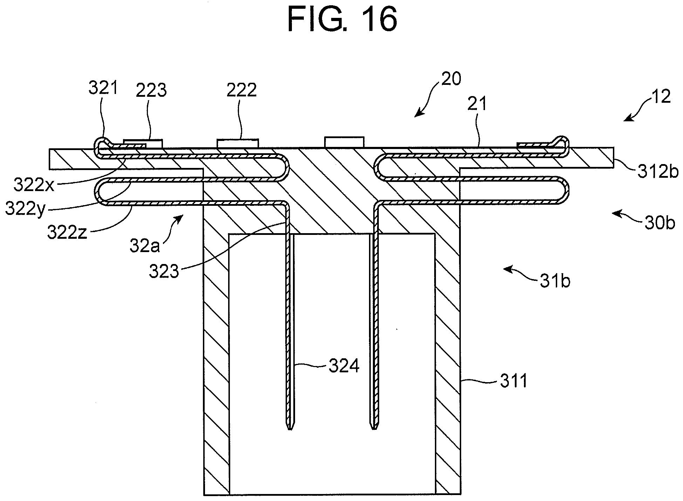

The housing in accordance with the fourth embodiment of the present invention is explained hereinbelow with reference to drawings. In Figure 16, parts or elements that correspond to those of the first embodiment illustrated in Figure 8 have been provided with the same reference numerals, and operate in the same manner as corresponding parts or elements in the first embodiment, unless explicitly explained hereinbelow.

As described later, the housing in accordance with the fourth embodiment is characterized that the thermally conductive part is partially exposed out of the housing 30b.

The flange 312b of LED lamp 12 illustrated in Figure 16 is designed to have a thickness smaller than the flange 312 illustrated in Figure 8, and accordingly, the thermally conductive part 322 is partially exposed out of the housing main body 31b.

In the fourth embodiment, a half of the second thermally conductive part 322y, a half of the third thermally conductive part 322z, and the bending part 325 connecting the second thermally conductive part 322y and the third thermally conductive part 322z to each other are exposed out of the housing main body 31b.

By designing the thermally conductive part 322 to be partially exposed out of the housing main body 31b, it is possible to radiate heat to ambient atmosphere as well as the housing 30b, temperature of LED 221 can be prevented from rising.

Though a part of the second thermally conductive part 322y, a part of the third thermally conductive part 322z, and the bending part 325 connecting the second thermally conductive part 322y and the third thermally conductive part 322z to each other are exposed out of the housing main body 31b, the second and third thermally conductive parts 322y and 322z may be entirely exposed out of the housing main body 31b, or only the third thermally conductive part 322z may be partially or entirely exposed out of the housing main body 31b.

In order to expose the wire section 32a out of the flange 312 illustrated in Figure 8, the thermally conductive part 322 embedded in the flange 312 may be bent to thereby downwardly project out of an outer periphery of the flange 312, for instance. The wire section 32a may be designed to have any shape such that the thermally conductive part 322 embedded therein is partially or entirely exposed out of the housing main body 31.

Similarly, the thermally conductive part 322 of the wire section 32 in the first embodiment (see Figure 4) may be designed to be partially or entirely exposed out of the housing main body 31.

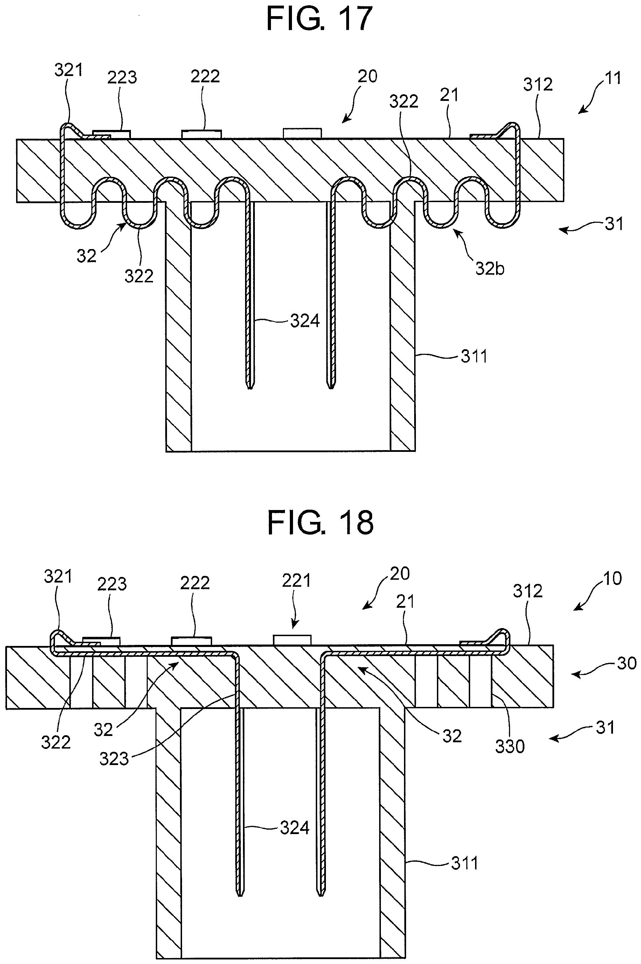

Similarly, the thermally conductive part 322 of the wire section 32b in the third embodiment (see Figure 15) may be designed to be partially or entirely exposed out of the housing main body 31, as illustrated in Figure 17.

### (Fifth Embodiment)

Figure 18 is a cross-sectional view of the housing in accordance with the fifth embodiment of the present invention.

In the above-mentioned fourth embodiment, the thermally conductive part 322 is designed to project out of the housing main body 31, as illustrated in Figures 17 and 18.

In the fifth embodiment, as illustrated in Figure 18, the housing 31 is formed with holes 330 leading to the thermally conductive part 322, and thus, the thermally conductive part 322 is exposed to atmosphere through the holes 330.

Thus, heat having transferred to the thermally conductive part 322 can be radiated to ambient atmosphere through the holes 330.

The housing in accordance with the fifth embodiment can provide the same advantages as those provided by the housing in accordance with the fourth embodiment.

### (Sixth Embodiment)

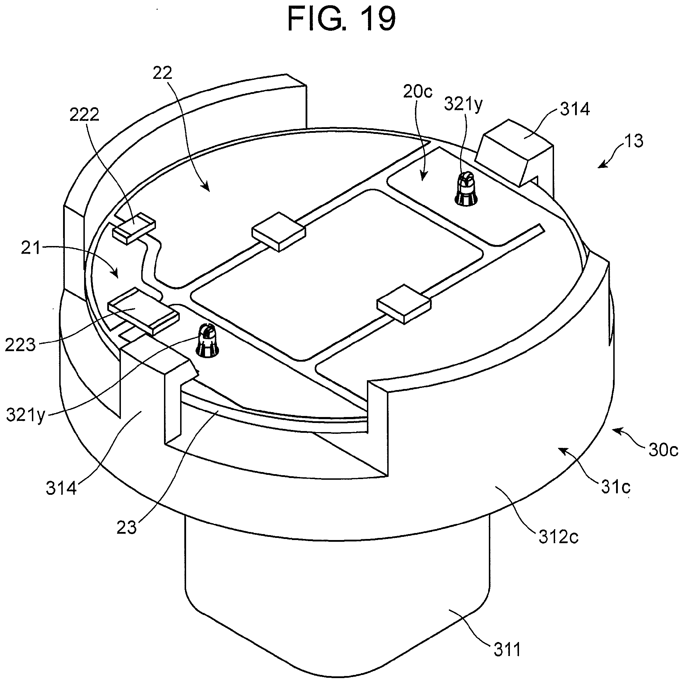

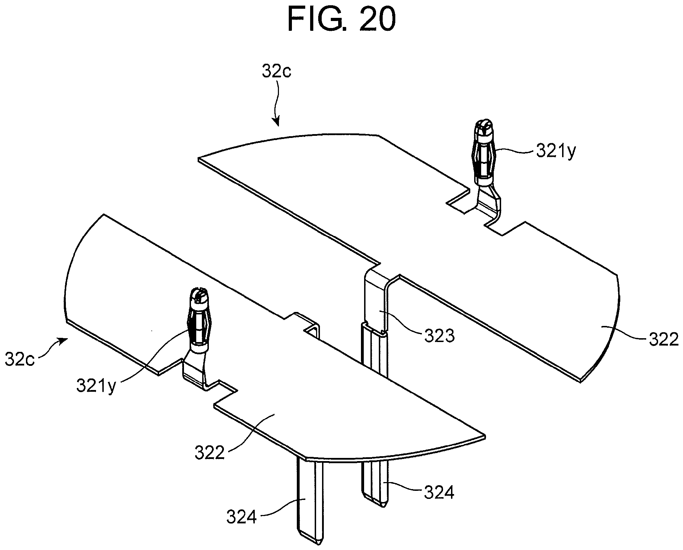

The housing in accordance with the sixth embodiment of the present invention is explained hereinbelow with reference to drawings. In Figures 19 and 20, parts or elements that correspond to those of the first embodiment illustrated in Figures 1 and 5 have been provided with the same reference numerals, and operated in the same manner as corresponding parts or elements in the first embodiment, unless explicitly explained hereinbelow.

The housing in accordance with the sixth embodiment is characterized in that the electric circuit 20 comprises a circuit board.

In the housing 30c to be used for LED lamp 13, illustrated in Figures 19 and 20, the flange 312c of the housing main body 31c is formed with a recess in which the electric circuit 20c in the form of a board is mounted, and further with a pair of hooks 314 for fixing the electric circuit 20c.

The electric circuit 20c includes an almost circular electrically insulated substrate 23, circuit patterns 21 formed on the electrically insulated substrate 23, and electric components 22 mounted on the circuit patterns 21.

In order to electrically connect to the circuit patterns 21 of the electric circuit 20c, the first terminal part 321y of the wire section 32c is formed in the form of a press-fit type terminal. The first terminal part 321y electrically connects to the circuit patterns 21 through a through-hole formed through the electrically insulated substrate 23. The through-hole formed through the electrically insulated substrate 23 is covered at an inner surface thereof with a thin metal film which is a part of the electric circuit 20c.

Even if the housing 30c and the electric circuit 20c were separately formed, the same advantages as those provided by the first to fifth embodiments can be obtained by forming the first terminal part 321y of the wire section 32c in the form of a press-fit type terminal, and electrically connecting the first terminal part 321y to the circuit patterns 21.

Furthermore, by designing the first terminal part 321y to be of a press-fit type terminal, the first terminal part 321y and the electric circuit 20c are able to electrically connect to each other merely by inserting the electric circuit 20c to the flange 312c, ensuring that the electric circuit 20c comprising a circuit board can be readily mounted on the housing 30c.

### (Seventh Embodiment)

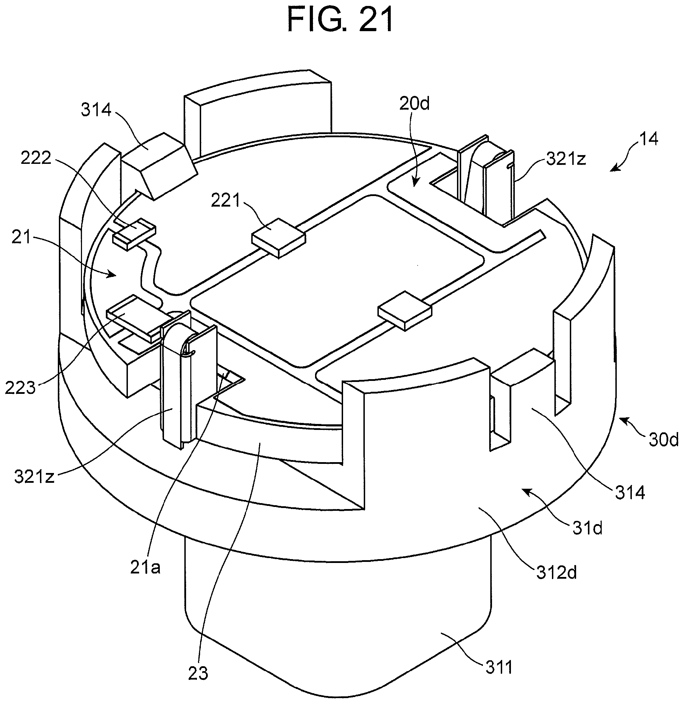

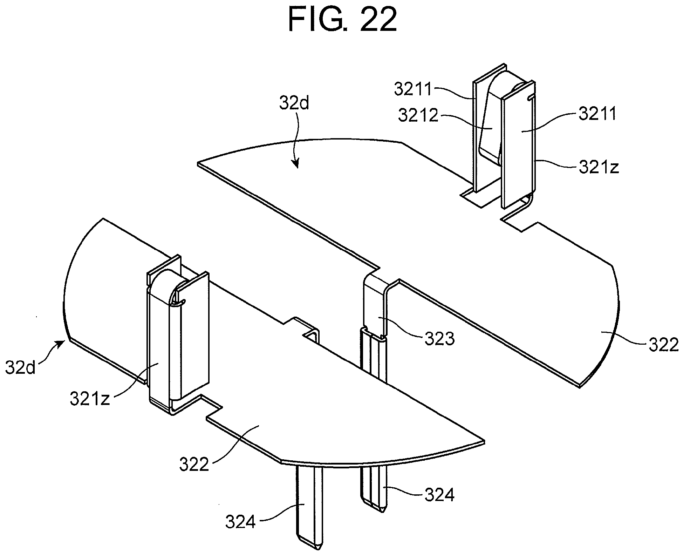

The housing in accordance with the seventh embodiment of the present invention is explained hereinbelow with reference to drawings. In Figures 21 and 22, parts or elements that correspond to those of the first embodiment illustrated in Figures 1, 5, 20 and 22 have been provided with the same reference numerals, and operate in the same manner as corresponding parts or elements in the first embodiment, unless explicitly explained hereinbelow.

The housing in accordance with the seventh embodiment is characterized in that the wire section and the electric circuit 20 comprising a circuit board are electrically connected via a plate spring contact.

In the housing 30d to be used for LED lamp 14, illustrated in Figures 21 and 22, the flange 312d of the housing main body 31d is formed with a recess in which the electric circuit 20d in the form of a board is mounted, and further with a pair of hooks 314 for fixing the electric circuit 20d.

The electric circuit 20d includes side patterns 21a each formed at a vertically extending surface of a cut-out formed at the electrically insulated substrate 23, and making contact with the first terminal part 321z of the wire section 32d. The side pattern 21a electrically connects to the circuit patterns 21 formed on an upper surface of the electrically insulated substrate 23.

The first terminal part 321z includes a pair of sidewalls 3211 standing on the thermally conductive part 322 and facing each other, and a spring contact 3212 bent at a distal end thereof.

Even if the housing 30d and the electric circuit 20d were separately formed, the same advantages as those provided by the first to fifth embodiments can be obtained by forming the first terminal part 321z of the wire section 32d in the form of a press-fit type terminal, and electrically connecting the first terminal part 321z to the circuit patterns 21 via the side pattern 21a.

Furthermore, by designing the first terminal part 321z to make electrical contact with the side pattern 21a via the spring contact 3212, the first terminal part 321z and the electric circuit 20d are able to electrically connect to each other merely by inserting the electric circuit 20d to the flange 312d, ensuring that the electric circuit 20d comprising a circuit board can be readily mounted on the housing 30d.

Though LED is explained as an example of an electric component in the above-mentioned first to seventh embodiments, the present invention can be applied to any electric components such as a transistor, a diode, a resistor, a capacitor and a coil, as far as they generate heat when a current runs therethrough.

In the above-mentioned first to seventh embodiments, the thermally conductive part 322 is formed between two bending portions of the wire section. For instance, in Figures 8 and 9, the first to third thermally conductive parts 322x, 322y and 322z are connected to one another via the bending parts 325. In place, the thermally conductive part 322 may be bent or folded such that the thermally conductive part 322 acts also as the junction part 323 (see Figure 4), or the thermally conductive part 322 has an area equal to a total of areas of the first and second thermally conductive parts 322x and 322y.

The wire sections 32c and 32d in the sixth and seventh embodiments are designed to include a single thermally conductive part, they may be designed to include a multi-layered thermally conductive part, similarly to the second and third embodiments.

### INDUSTRIAL APPLICABILITY

The present invention makes it possible to prevent a temperature of an electric component which generates heat when a current runs therethrough, from rising. Accordingly, the present invention is preferably suitable to a housing used for an electric circuit mounting thereon electric components which generate heat and thus are kept at a high temperature. In particular, the present invention is suitable to a housing used for a LED lamp in which LED emits light.

## Claims

1. A housing (30c, 30d) including:
a housing body (31c, 31d) in which a circuit board (23) is to be_mounted; and
a wire section (32c) through which electricity is supplied to the circuit board (23) from an electric power source,
the wire section (32c) including:
a pair of first sections (322) embedded in the housing body (31c, 31d);
a pair of second sections (321y, 321z) each projecting from each of the first sections (322) to electrically connect with the circuit board (23); and
a pair of third sections (323, 324) each projecting from each of the first sections (322) in a direction opposite to a direction in which the second sections (321y, 321z) project from the first sections (322), to electrically connect with the electric power source,
the first sections (322) each conducting heat having been generated in the circuit board (23) into the housing body (31c, 31d), **characterized by**
the first sections (322) each being arranged in parallel with the circuit board (23) in the housing body (31c, 31d).

2. The housing (30c) as set forth in claim 1, wherein each of the second sections (321y) is comprised of a press-fit terminal (321y) adapted to be fit into a through-hole formed through the circuit board (23).

3. The housing (30c) as set forth in claim 2, wherein the press-fit terminal (321y) corresponding to one of the first sections (322) and the press-fit terminal (321y) corresponding to the other of the first sections (322) are situated across a diameter of the circuit board (23).

4. The housing (30d) as set forth in claim 1, wherein each of the second sections (321z) includes a spring contact (3212) having elasticity such that the second sections (321z) make electrical contact with the circuit board (23).

5. The housing (30d) as set forth in claim 4, wherein each of the second sections (321z) further includes a pair of sidewalls (3211) surrounding opposite sides of the spring contact (3212).

6. The housing (30d) as set forth in claim 4 or 5, wherein the spring contact (3212) corresponding to one of the first sections (322) and the spring contact (3212) corresponding to the other of the first sections (322) are situated across a diameter of the circuit board (23).

7. The housing (30c, 30d) as set forth in any one of claims 1 to 3, wherein the housing body (31c, 31d) includes at least one hook (314) to sandwich the circuit board (23) between the hook (314) and the housing body (31c, 31d) at a periphery of the circuit board (23).

8. The housing (30c, 30d) as set forth in any one of claims 1 to 7, wherein each of the first sections (322) has a width greater than the same of the second sections (321y, 321z) and the third sections (323, 324),
each of the first sections (322) comprising a plurality of vertically or horizontally arranged layers (322x, 322y, 322z),
the layers (322x, 322y, 322z) being arranged to be spaced away from one another,
the adjacent layers (322x, 322y, 322z) being connected to each other through a bending part (325) formed at peripheries of the adjacent layers,
each of the layers (322x, 322y, 322z) being arranged in parallel with one another.

9. The housing (30c, 30d) as set forth in claim 8, wherein each of the layers (322x, 322y, 322z) is formed with at least one through-hole (326) into which a pole (PU1-PU6, PD1-PD6) can be inserted perpendicularly to the layers (322x, 322y, 322z).

10. The housing (30c, 30d) as set forth in claim 9, wherein each of the first sections (322) has an area extensive almost over the housing body (31c, 31d).

11. The housing (30c, 30d) as set forth in any one of claims 1 or 10, wherein at least a part of each of the first sections (322) is exposed externally of the housing body (31c, 31d).

12. The housing (30c, 30d) as set forth in claim 11, wherein the housing body (31c, 31d) is formed with at least one hole (330) leading to the first sections (322).

13. The housing (30c, 30d) as set forth in any one of claims 1 to 12, further including an electrically conductive pattern (21) formed on a surface of the circuit board (23), the pattern (21) being comprised of a thin metal film, the pattern (21) being manufactured by punching a thin metal sheet, and transferring the thus punched sheet onto the circuit board (23).

## Patentansprüche

1. Ein Gehäuse (30c, 30d) mit:
einem Gehäusekörper (31c, 31d), in dem eine Leiterplatte (23) zu montieren ist; und
einem Drahtabschnitt (32c), durch den der Leiterplatte (23) Elektrizität von einer elektrischen Stromquelle zugeführt wird,
wobei der Drahtabschnitt (32c) Folgendes umfasst:
ein Paar erster Abschnitte (322), die in den Gehäusekörper (31c, 31d) eingebettet sind;
ein Paar zweiter Abschnitte (321y, 321z), die jeweils von jedem der ersten Abschnitte (322) vorstehen, um eine elektrische Verbindung mit der Leiterplatte (23) herzustellen; und
ein Paar dritter Abschnitte (323, 324), die jeweils von jedem der ersten Abschnitte (322) in einer Richtung entgegengesetzt zu einer Richtung vorstehen, in der die zweiten Abschnitte (321y, 321z) von den ersten Abschnitten (322) vorstehen, um eine elektrische Verbindung mit der elektrischen Energiequelle herzustellen,
wobei die ersten Abschnitte (322) jeweils Wärme, die in der Leiterplatte (23) erzeugt wurde, in den Gehäusekörper (31c, 31d) leiten, **dadurch gekennzeichnet, dass**
die ersten Abschnitte (322) jeweils parallel zur Leiterplatte (23) im Gehäusekörper (31c, 31d) angeordnet sind.

2. Gehäuse (30c) nach Anspruch 1, wobei jeder der zweiten Abschnitte (321y) einen Einpressanschluss (321y) umfasst, der so angepasst ist, dass er in ein durch die Leiterplatte (23) ausgebildetes Durchgangsloch passt.

3. Gehäuse (30c) nach Anspruch 2, wobei der Einpressanschluss (321y), der zu einem der ersten Abschnitte (322) gehört, und der Einpressanschluss (321y), der zu dem anderen der ersten Abschnitte (322) gehört, so angeordnet sind, dass sie einander über einen Durchmesser der Leiterplatte (23) gegenüberliegen.

4. Gehäuse (30d) nach Anspruch 1, wobei jeder der zweiten Abschnitte (321z) einen Federkontakt (3212) mit einer derartigen Elastizität aufweist, dass die zweiten Abschnitte (321z) einen elektrischen Kontakt mit der Leiterplatte (23) herstellen.

5. Gehäuse (30d) nach Anspruch 4, wobei jeder der zweiten Abschnitte (321z) ferner ein Paar von Seitenwänden (3211) aufweist, die gegenüberliegende Seiten des Federkontakts (3212) umgeben.

6. Gehäuse (30d) nach Anspruch 4 oder 5, wobei der Federkontakt (3212), der zu einem der ersten Abschnitte (322) gehört, und der Federkontakt (3212), der zu dem anderen der ersten Abschnitte (322) gehört, so angeordnet sind, dass sie einander über einen Durchmesser der Leiterplatte (23) gegenüberliegen.

7. Gehäuse (30c, 30d) nach einem der Ansprüche 1 bis 3, wobei der Gehäusekörper (31c, 31d) mindestens einen Haken (314) aufweist, um die Leiterplatte (23) zwischen dem Haken (314) und dem Gehäusekörper (31c, 31d) an einem Randbereich der Leiterplatte (23) sandwichartig anzuordnen.

8. Gehäuse (30c, 30d) nach einem der Ansprüche 1 bis 7, wobei jeder der ersten Abschnitte (322) eine Breite aufweist, die größer als die der zweiten Abschnitte (321y, 321z) und der dritten Abschnitte (323, 324) ist,
wobei jeder der ersten Abschnitte (322) eine Vielzahl von vertikal oder horizontal angeordneten Schichten (322x, 322y, 322z) umfasst,
wobei die Schichten (322x, 322y, 322z) so angeordnet sind, dass sie voneinander beabstandet sind,
wobei die benachbarten Schichten (322x, 322y, 322z) durch ein Biegeteil (325) miteinander verbunden sind, das an den Rändern der benachbarten Schichten ausgebildet ist,
wobei alle Schichten (322x, 322y, 322z) parallel zueinander angeordnet sind.

9. Gehäuse (30c, 30d) nach Anspruch 8, wobei jede der Schichten (322x, 322y, 322z) mit mindestens einem Durchgangsloch (326) ausgebildet ist, in das ein Stab (PU1-PU6, PD1-PD6) senkrecht zu den Schichten (322x, 322y, 322z) einführbar ist.

10. Gehäuse (30c, 30d) nach Anspruch 9, wobei jeder der ersten Abschnitte (322) eine Fläche aufweist, die sich über fast den gesamten Gehäusekörper (31c, 31d) erstreckt.

11. Gehäuse (30c, 30d) nach einem der Ansprüche 1 oder 10, wobei zumindest ein Teil jedes der ersten Abschnitte (322) außerhalb des Gehäusekörpers (31c, 31d) freiliegt.

12. Gehäuse (30c, 30d) nach Anspruch 11, wobei der Gehäusekörper (31c, 31d) mindestens ein Loch (330) aufweist, das zu den ersten Abschnitten (322) führt.

13. Gehäuse (30c, 30d) nach einem der Ansprüche 1 bis 12, weiter mit einem elektrisch leitenden Muster (21), das auf einer Oberfläche der Leiterplatte (23) ausgebildet ist, wobei das Muster (21) aus einem dünnen Metallfilm besteht und das Muster (21) durch Stanzen eines dünnen Metallblechs und Übertragen des so gestanzten Blechs auf die Leiterplatte (23) hergestellt wird.

## Revendications

1. Boîtier (30c, 30d) incluant :
un corps de boîtier (31c, 31d) dans lequel une carte de circuit imprimé (23) doit être montée ; et
une section de fil (32c) à travers laquelle de l'électricité est fournie à la carte de circuit imprimé (23) à partir d'une source d'alimentation électrique,
la section de fil (32c) incluant :
une paire de premières sections (322) intégrées dans le corps de boîtier (31c, 31d) ;
une paire de deuxièmes sections (321y, 321z) faisant chacune saillie à partir de chacune des premières sections (322) pour se connecter électriquement à la carte de circuit imprimé (23) ; et
une paire de troisièmes sections (323, 324) faisant chacune saillie à partir de chacune des premières sections (322) dans une direction opposée à une direction dans laquelle les deuxièmes sections (321y, 321z) font saillie à partir des premières sections (322), pour se connecter électriquement à la source d'alimentation électrique,
les premières sections (322) conduisant chacune la chaleur ayant été générée dans la carte de circuit imprimé (23) dans le corps de boîtier (31c, 31d), **caractérisé par**
les premières sections (322) étant chacune agencées en parallèle avec la carte de circuit imprimé (23) dans le corps de boîtier (31c, 31d).

2. Boîtier (30c) selon la revendication 1, dans lequel chacune des deuxièmes sections (321y) se compose d'une borne à ajustement par pression (321y) adaptée pour être ajustée dans un trou traversant formé à travers la carte de circuit imprimé (23).

3. Boîtier (30c) selon la revendication 2, dans lequel la borne à ajustement par pression (321y) correspondant à l'une des premières sections (322) et la borne à ajustement par pression (321y) correspondant à l'autre des premières sections (322) sont situées sur un diamètre de la carte de circuit imprimé (23).

4. Boîtier (30d) selon la revendication 1, dans lequel chacune des deuxièmes sections (321z) inclut un contact à ressort (3212) ayant une élasticité telle que les deuxièmes sections (321z) établissent un contact électrique avec la carte de circuit imprimé (23).

5. Boîtier (30d) selon la revendication 4, dans lequel chacune des deuxièmes sections (321z) inclut en outre une paire de parois (3211) entourant les côtés opposés du contact à ressort (3212).

6. Boîtier (30d) selon la revendication 4 ou 5, dans lequel le contact à ressort (3212) correspondant à l'une des premières sections (322) et le contact à ressort (3212) correspondant à l'autre des premières sections (322) sont situés sur un diamètre de la carte de circuit imprimé (23).

7. Boîtier (30c, 30d) selon l'une quelconque des revendications 1 à 3, dans lequel le corps de boîtier (31c, 31d) inclut au moins un crochet (314) pour intercaler la carte de circuit imprimé (23) entre le crochet (314) et le corps de boîtier (31c, 31d) au niveau d'une périphérie de la carte de circuit imprimé (23).

8. Boîtier (30c, 30d) selon l'une quelconque des revendications 1 à 7, dans lequel chacune des premières sections (322) a une largeur supérieure à celle des deuxièmes sections (321y, 321z) et des troisièmes sections (323, 324),
chacune des premières sections (322) comprenant une pluralité de couches (322x, 322y, 322z) agencées verticalement ou horizontalement,
les couches (322x, 322y, 322z) étant agencées pour être espacées les unes des autres,
les couches (322x, 322y, 322z) adjacentes étant connectées les unes aux autres à travers une partie courbée (325) formée au niveau des périphéries des couches adjacentes,
chacune des couches (322x, 322y, 322z) étant agencées parallèlement les unes aux autres.

9. Boîtier (30c, 30d) selon la revendication 8, dans lequel chacune des couches (322x, 322y, 322z) est formée avec au moins un trou traversant (326) dans lequel un pôle (PU1-PU6, PD1-PD6) peut être inséré perpendiculairement aux couches (322x, 322y, 322z).

10. Boîtier (30c, 30d) selon la revendication 9, dans lequel chacune des premières sections (322) a une zone étendue presque sur le corps de boîtier (31c, 31d).

11. Boîtier (30c, 30d) selon l'une quelconque des revendications 1 ou 10, dans lequel au moins une partie de chacune des premières sections (322) est exposée à l'extérieur du corps de boîtier (31c, 31d).

12. Boîtier (30c, 30d) selon la revendication 11, dans lequel le corps de boîtier (31c, 31d) est formé avec au moins un trou (330) conduisant aux premières sections (322).

13. Boîtier (30c, 30d) selon l'une quelconque des revendications 1 à 12, incluant en outre un motif électroconductreur (21) formé sur une surface de la carte de circuit imprimé (23), le motif (21) se composant d'un film métallique mince, le motif (21) étant fabriqué par poinçonnage d'une feuille métallique mince, et transfert de la feuille ainsi poinçonnée sur la carte de circuit imprimé (23).
